# EUROPEAN PATENT SPECIFICATION

(11) **EP 3 843 519 B1**
(45) Date of publication and mention of the grant of the patent: **06.09.2023**
(21) Application number: 18930683.0
(22) Date of filing: 24.08.2018
(51) Int. Cl.: H05K 13/02, H05K 13/08

(54) **COMPONENT MOUNTING MACHINE AND COMPONENT COLLECTION METHOD**
KOMPONENTENMONTAGEMASCHINE UND KOMPONENTENSAMMELVERFAHREN
MACHINE DE MONTAGE DE COMPOSANTS ET PROCÉDÉ DE COLLECTE DE COMPOSANTS

(43) Date of publication of application: 30.06.2021
(73) Proprietor: Fuji Corporation, Chiryu-shi, Aichi 472-8686 (JP)
(72) Inventor: SUGIHARA, Kohei, Chiryu-shi, Aichi 472-8686 (JP)
(74) Representative: Grünecker Patent- und Rechtsanwälte PartG mbB
(86) International application number: PCT/JP2018/031275
(87) International publication number: WO 2020/039569

(56) References cited:
- EP-A1- 3 041 337
- EP-A1- 3 125 666
- WO-A1-2015/029123
- JP-A- H0 685 492
- JP-A- 2003 031 994
- JP-A- 2014 096 467

## Description

### Technical Field

The present specification discloses techniques related to a component mounter and a component picking up method.

### Background Art

A surface mounter described in Patent Literature 1 is provided with a component supply device, monitoring means, and head control means. Component supply device executes a supply operation of the electronic component based on a supply operation program for supplying an electronic component to a component supply position in accordance with a time when it takes for a mounting head to reach a position where a pickup operation is executed. The monitoring means detects a delay in the supply operation for the supply operation program and generates a signal. The head control means controls a movement of the mounting head when the signal is received.

A mounting device described in Patent Literature 2 is provided with imaging means, illuminant coordinates detection means, and control means. The imaging means acquires an image of a light emitting component by imaging a region including at least a portion of an illuminant of the light emitting component. The illuminant coordinates detection means detects coordinates of a specific part of the illuminant based on the image of the light emitting component. The control means holds the light emitting component to move the light emitting component onto the board based on the detected coordinates of the specific part, and mounts the light emitting component so that the specific part of the illuminant is positioned at predetermined coordinates on the board.

### Patent Literature

Patent Literature 1: JP-A-2009-231366
Patent Literature 2: WO 2016/020975
Patent Literature 3: EP 3 041 337 A1 relates to component mounting device. Components are imaged by a board camera and identified using image processing. Before picking up, the center position of a component is identified and positional correction is performed.
Patent Literature 4: EP 3 125 666 A1 relates to an electronic mounting apparatus. A camera images a component extraction position where a component is to be extracted from a component feeding unit. Based on an image captured by the camera, a positional deviation between the component extraction position and a position of a housing portion where a component is stored in the component deeding unit or a position of the component in the housing portion is recognized. The component extraction position is corrected to a position shifted by the recognized positional deviation.

### Summary of the Invention

### Technical Problem

For all components supplied from a component supply device to a board, when the components are imaged before the components are picked up and a supply state determination that determines whether a supply state of the components is appropriate is executed, a cycle time of a component mounter may increase. In addition, in the component mounter for executing the supply state determination of the component, since the imaging is required, a lowering operation of a holding member for picking up the component is started after the component is positioned at a picking up position.

In view of such circumstances, the present specification discloses a component mounter and a component picking up method which can determine necessity of a supply state determination for the component to be supplied after supplying a predetermined number of components from a component supply device, and set an operation start timing at which a holding member starts a lowering operation for picking up the component.

### Solution to Problem

The invention is defined by the features of the independent claims. Embodiments and examples not falling under the scope of the independent claims are for illustrational purposes only.

### Advantageous Effect of the Invention

According to the above-described component mounter, the first determination section, the second determination section, and the timing setting section are provided. As a result, the above-described component mounter can determine the necessity of the supply state determination for the second component based on the result of determination by the first determination section. In addition, the above-described component mounter can set the operation start timing for both the first component and the second component. The above description for component mounter can be similarly said for the component picking up method.

### Brief Description of Drawings

[Fig. 1] It is a plan view illustrating a configuration example of component mounter 10.
[Fig. 2] It is a side view illustrating a configuration example of component mounting head 20.
[Fig. 3] It is a block diagram illustrating an example of a control block of component mounter 10.
[Fig. 4A] It is a flowchart illustrating an example of a control procedure by first determination section 41, second determination section 42, and timing setting section 43.
[Fig. 4B] It is a flowchart illustrating an example of a control procedure by holding member control section 44.
[Fig. 4C] It is a flowchart illustrating an example of a control procedure by initialization section 45.
[Fig. 5] It is a plan view illustrating an example of a supply state of first component 81 when first component 81 is positioned at imaging position PC1.
[Fig. 6A] It is a schematic diagram illustrating an example of first timing TG1.
[Fig. 6B] It is a schematic diagram illustrating an example of second timing TG2.
[Fig. 7] It is a plan view illustrating an example of component supply device 12 in which imaging position PC1 and picking up position PP1 are different from each other.
[Fig. 8] It is a flowchart illustrating another example of a control procedure by first determination section 41, second determination section 42, and timing setting section 43.

### Description of Embodiments

### 1. Embodiment

### 1-1. Configuration Example of Component Mounter 10

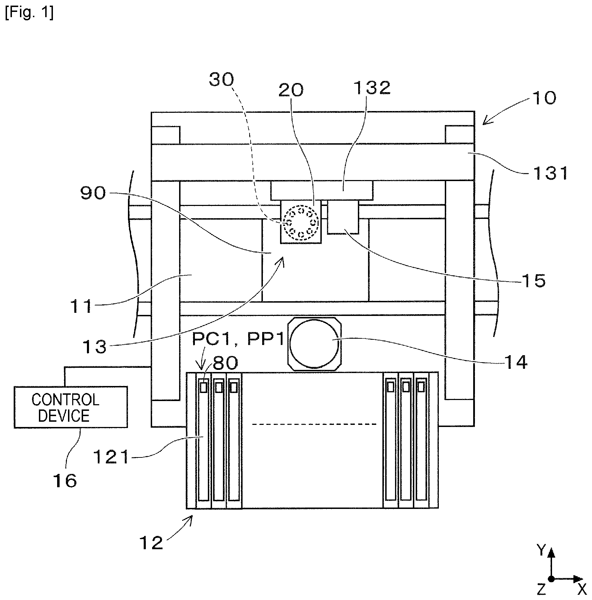

As illustrated in Fig. 1, component mounter 10 is provided with board conveyance device 11, component supply device 12, component transfer device 13, part camera 14, board camera 15, and control device 16. Board conveyance device 11 includes a belt conveyor or the like, and conveys board 90 in a conveyance direction (X-axis direction). Board 90 is a circuit board and forms at least one of an electronic circuit and an electrical circuit. Board conveyance device 11 carries board 90 into the component mounter 10 and positions board 90 at a predetermined position in the mounter. Board conveyance device 11 carries board 90 out of the component mounter 10 after mounting processing of component 80 by component mounter 10 is ended.

Component supply device 12 sequentially supplies components 80 to be mounted on board 90. Specifically, component supply device 12 is provided with multiple feeders 121 provided along the conveyance direction of board 90 (X-axis direction). Each of multiple feeders 121 pitch-feeds a carrier tape storing multiple components 80 to supply component 80 so that component 80 can be picked up at picking up position PP1 provided on a tip end side of feeder 121.

Component transfer device 13 is provided with head driving device 131 and moving body 132. Head driving device 131 is configured so that moving body 132 is movable in the X-axis direction and the Y-axis direction by a linear motion mechanism. Moving body 132 is provided with component mounting head 20 detachable (exchangeable) by a clamp member (not illustrated). Component mounting head 20 mounts component 80 on board 90 on which component 80 is picked up and positioned. Specifically, component mounting head 20 picks up component 80 supplied by component supply device 12 by holding member 30, and mounts component 80 at a predetermined mounting position of positioned board 90.

For example, as part camera 14 and board camera 15, a digital imaging device having an imaging element can be used. For example, as the imaging element, a charge coupled device (CCD) or an image sensor such as a complementary metal oxide semiconductor (CMOS) can be used. Part camera 14 and board camera 15 execute imaging based on a control signal transmitted from control device 16. Part camera 14 and board camera 15 transmit image data acquired by imaging to control device 16.

Part camera 14 is fixed to the base of component mounter 10 so that an optical axis faces upward in the Z-axis direction (vertical upward direction). Part camera 14 is configured so that component 80 held by holding member 30 can be imaged from below. Board camera 15 is provided on moving body 132 of component transfer device 13 so that an optical axis faces downward in the Z-axis direction (vertical downward direction). Board camera 15 is configured so that board 90 can be imaged from above. In addition, board camera 15 can also image component 80 from above at imaging position PC1 (in the present embodiment, the same position as picking up position PP1) of component 80.

Control device 16 is provided with a known central arithmetic unit and storage device, and includes a control circuit (both are not illustrated). The central arithmetic unit is a CPU: central processing unit and can execute various calculation processing. The storage device is provided with a first storage device and a second storage device. The first storage device is a volatile storage device (random access memory: RAM) and the second storage device is a non-volatile storage device (read only memory: ROM). In the mounting processing of mounting component 80 on board 90, information output from various multiple sensors provided in component mounter 10 and the result of recognition processing by image processing or the like are input to control device 16. Control device 16 transmits a control signal to component transfer device 13 based on a control program, predetermined mounting conditions set in advance, and the like.

Control device 16 can image component 80 before component 80 is picked up at picking up position PP1 and execute a supply state determination that determines whether the supply state of component 80 in component supply device 12 is appropriate. Component 80 can be imaged, for example, by board camera 15. Control device 16 can also control the position and angle of holding member 30 before picking up component 80 by holding member 30.

In addition, control device 16 may also control the position and angle of holding member 30 after component 80 is picked up and held by holding member 30. Specifically, control device 16 images component 80 held by holding member 30 using part camera 14. Control device 16 recognizes the posture of component 80 in holding member 30 based on the image data acquired by imaging part camera 14. At this time, for example, control device 16 can recognize the posture of component 80 by obtaining the portion of component 80 which is a reference position for positioning with respect to board 90, the portion characteristic of the appearance of component 80, and the like by image processing.

Next, control device 16 moves component mounting head 20 toward above a predetermined position on board 90. At this time, control device 16 corrects the position and angle of holding member 30 based on the posture of component 80 recognized by the image processing. Control device 16 mounts component 80 on board 90 by lowering holding member 30. Component 80 mounted on board 90 is held by a tack force caused by, for example, viscosity of a bonding material (for example, cream solder) previously applied to the upper surface of board 90. Control device 16 repeats the pick-and-place cycle described above to execute the mounting processing of mounting component 80 on board 90. In the present specification, the time required for the pick-and-place cycle described above is referred to as a cycle time.

### 1-2. Configuration Example of Component Mounting Head 20

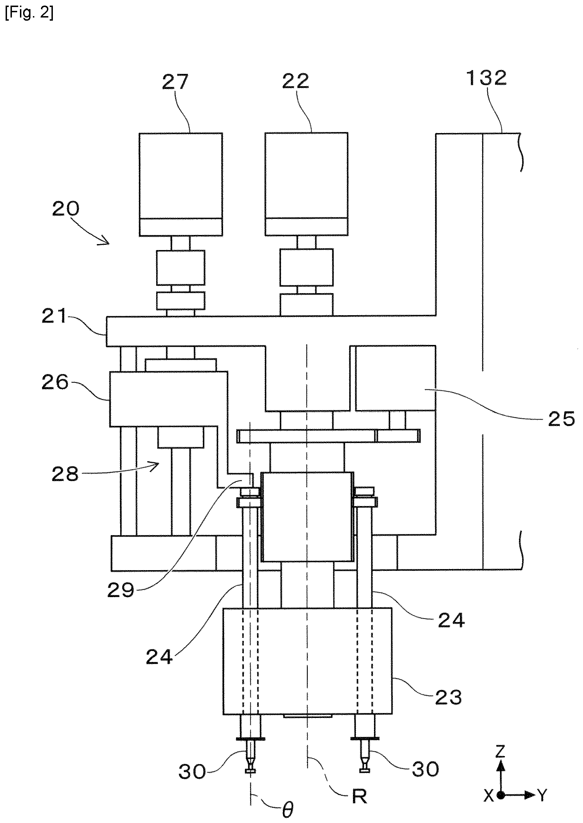

As illustrated in Fig. 2, component mounting head 20 is provided with head main body 21 which is clamped to moving body 132. Head main body 21 is provided with rotary head 23 so that a rotation angle can be indexed for each predetermined angle by R-axis motor 22. Rotary head 23 holds multiple (for example, 12 pieces) tool shafts 24 at equal intervals in the circumferential direction on a circumference concentric with the R-axis so as to be slidable in the θ-axis direction parallel to the Z-axis and the R-axis (vertical direction in Fig. 2) and rotatably around the θ-axis.

Tool shaft 24 is biased upward with respect to rotary head 23 by the elastic force of the spring (not illustrated). As a result, tool shaft 24 is positioned at a lifting end in the normal state where no external force is applied. Holding member 30 is detachably attached to a lower end portion of tool shaft 24. Positive pressure air or negative pressure air is supplied to holding member 30 to pick up component 80. Holding member 30 includes a chuck (not illustrated) operated by positive pressure air or negative pressure air or the like, in addition to a suction nozzle for picking up component 80 by negative pressure air. In addition, when holding member 30 is attached to tool shaft 24, holding member 30 is biased downward by the elastic force of the in-shaft spring (not illustrated).

Each of multiple holding members 30 holds component 80 by supplying air to an air passage (not illustrated) of holding member 30. Multiple holding members 30 are subsequently indexed to predetermined angle positions around the R-axis (for example, lifting and lowering position of tool shaft 24) by rotating rotary head 23 as R-axis motor 22 is driven. As illustrated in Fig. 2, component mounting head 20 is provided with θ-axis motor 25 fixed to head main body 21. All tool shafts 24 are connected to the output shaft of θ-axis motor 25 so that rotational force can be transmitted via multiple gears. Tool shaft 24 and holding member 30 are integrally rotated (revolved) around the θ-axis by the operation of θ-axis motor 25, the rotation angle and the rotation speed are controlled.

In addition, head main body 21 is provided with actuating member 26 so as to be movable in the Z-axis direction (vertical upward-downward direction). Actuating member 26 is lifted and lowered in the Z-axis direction by ball screw mechanism 28 operated by the drive of Z-axis motor 27. Actuating member 26 is provided with lever 29 which contacts an upper end portion of tool shaft 24 indexed to the lifting and lowering position of multiple tool shafts 24. Lever 29 is lowered with the movement of actuating member 26 downward in the Z-axis direction. Lever 29 presses tool shaft 24 downward in the Z-axis direction against the elastic force of the spring of tool shaft 24 in contact with lever 29, and lowers tool shaft 24. Tool shaft 24 and holding member 30 are integrally lifted and lowered in the Z-axis direction by the drive of Z-axis motor 27, and the position and the movement speed in the Z-axis direction are controlled.

### 1-3. Example of Supply State Determination and Operation Start Timing Setting

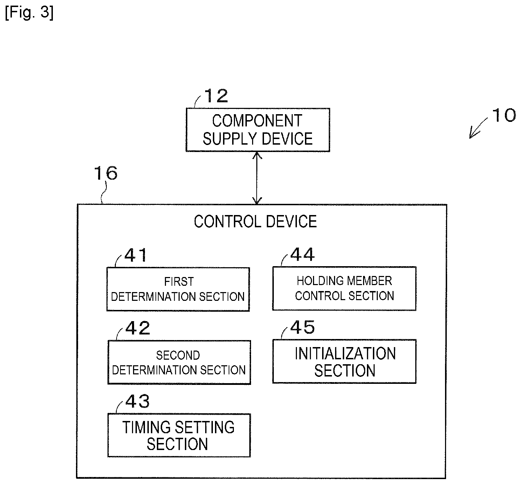

As described above, component mounter 10 is provided with component supply device 12, and control device 16. Component supply device 12 sequentially supplies components 80 to be mounted on board 90. Control device 16 is provided with first determination section 41, second determination section 42, and timing setting section 43 when regarded as a control block. It is preferable that control device 16 is further provided with at least one of holding member control section 44 and initialization section 45. As illustrated in Fig. 3, control device 16 of the present embodiment is provided with first determination section 41, second determination section 42, timing setting section 43, holding member control section 44, and initialization section 45.

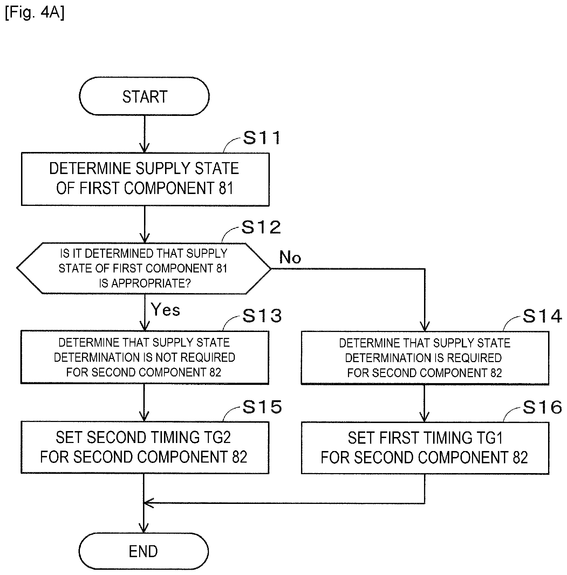

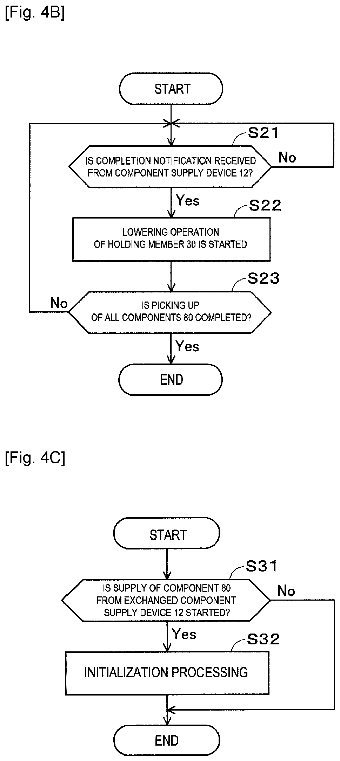

In addition, control device 16 executes a control program according to the flowcharts illustrated in Figs. 4A, 4B, and 4C. First determination section 41 executes the processing illustrated in Step S11. Second determination section 42 executes the determination illustrated in Step S12. In addition, second determination section 42 executes the processing illustrated in Step S13 and Step S14. Timing setting section 43 executes the processing illustrated in Step S15 and Step S16. Holding member control section 44 executes the determination illustrated in Step S21 and Step S23. In addition, holding member control section 44 executes the processing illustrated in Step S22. Initialization section 45 executes the determination illustrated in Step S31. In addition, Initialization section 45 executes the processing illustrated in Step S32.

### 1-3-1. First Determination Section 41

First determination section 41 executes the supply state determination for first component 81 (Step S11). First components 81 refer to a predetermined number of components 80 which is smaller than the number of components 80 supplied from component supply device 12 to board 90. Although the above-described predetermined number is not limited, it is preferable that a predetermined number is one. In addition, it is preferable that first component 81 is first component 80 first supplied from component supply device 12.

Since component supply device 12 sequentially supplies components 80 to be mounted on board 90, there is a high possibility that the same supply state is continuous. In particular, in a case where same component supply device 12 (for example, same feeder 121) supplies the same type of components 80 manufactured in the same lot by the same manufacturer, the possibility that the same supply state continues is further increased. Specifically, the possibility is high that the position and angle of component 80 when first component 80 first supplied from component supply device 12 is positioned at imaging position PC1 (picking up position PP1) and the position and angle of component 80 supplied from component supply device 12 after component 80 is supplied are included in a predetermined range (allowable range). Therefore, first determination section 41 of the present embodiment executes the supply state determination of first component 81, which is first component 80 first supplied from component supply device 12.

The supply state determination refers to imaging component 80 before component 80 is picked up at picking up position PP1 illustrated in Fig. 1, and determining whether the supply state of component 80 in component supply device 12 is appropriate. The imaging means and the imaging method are not limited. First determination section 41 can image component 80 positioned at imaging position PC1 (picking up position PP1) by using, for example, board camera 15. It is preferable that first determination section 41 determines that the supply state of first component 81 is appropriate when both the position and the angle of first component 81 when first component 81 is positioned at imaging position PC1 are included in the predetermined ranges. In addition, it is preferable that first determination section 41 determines that the supply state of first component 81 is inappropriate when at least one of the position and the angle of first component 81 when first component 81 is positioned at imaging position PC1 is not included in the predetermined range.

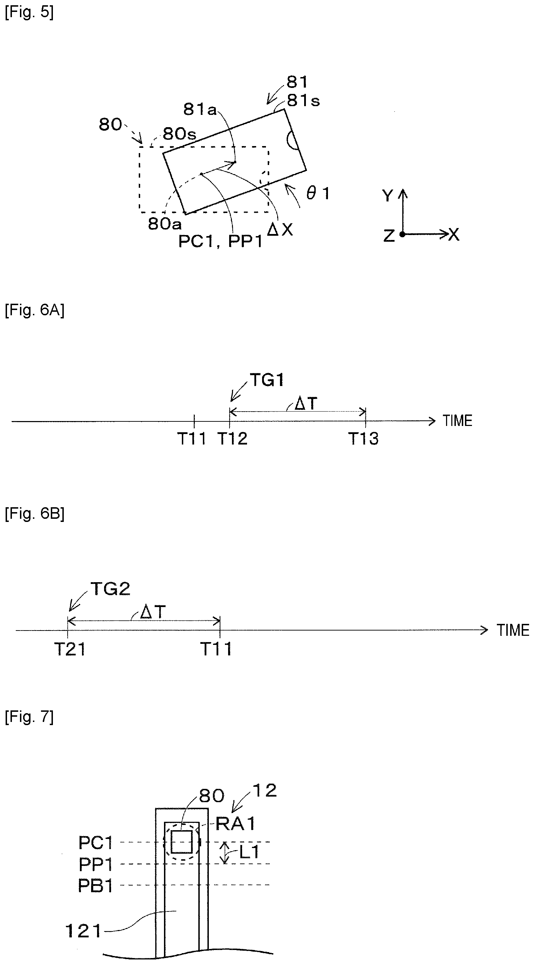

Component 80 illustrated by a broken line in Fig. 5 is positioned so that center position 80a of component 80 does not rotate at imaging position PC1 (picking up position PP1). First component 81 illustrated by a solid line in the figure is positioned by rotating counterclockwise by an angle θ1 at a position where center position 81a of first component 81 is moved by a deviation ΔX from imaging position PC1 (picking up position PP1). Outer shape 80s (rectangular shape in the figure) and center position 80a of component 80, and outer shape 81s (rectangular shape in the figure) and center position 81a of first component 81 can be obtained by, for example, image processing a captured image captured by board camera 15. As described above, it is preferable that first determination section 41 acquires the position and angle of first component 81 when first component 81 is positioned at imaging position PC1 (picking up position PP1), based on outer shape 81s and center position 81a of first component 81 obtained by image processing a captured image obtained by imaging first component 81.

First determination section 41 determines that the supply state of first component 81 is appropriate when the position of first component 81 when first component 81 is positioned at imaging position PC1 (picking up position PP1) is within a predetermined range (allowable range) and the angle θ1 is within a predetermined range (allowable range). For example, the position of first component 81 can be represented by a center position 81a or a deviation ΔX. In this case, control device 16 can adjust picking up position PP1 and the angle of holding member 30 in accordance with the supply state of first component 81. First determination section 41 determines that the supply state of first component 81 is inappropriate when at least one of the position (center position 81a or deviation ΔX) and the angle θ1 of first component 81 when first component 81 is positioned at imaging position PC1 (picking up position PP1) is not included in the predetermined range (allowable range). In this case, the supply state of first component 81 is different from the supply state scheduled by the control program, mounting conditions, and the like, and for example, the manufacturer and production lot of first component 81 may be different.

### 1-3-2. Second Determination Section 42

Second determination section 42 determines the necessity of the supply state determination for second component 82 based on a result of determination by first determination section 41. Second component 82 refers to component 80 supplied from component supply device 12 after first component 81 is supplied. In the present embodiment, second component 82 is second and subsequent components 80 supplied from component supply device 12 to board 90.

Second determination section 42 determines whether first determination section 41 determines that the supply state of first component 81 is appropriate (Step S12 illustrated in Fig. 4A). In a case where first determination section 41 determines that the supply state of first component 81 is appropriate (case of Yes in Step S12), it is preferable that second determination section 42 determines that the supply state determination is not required for second component 82 (Step S13). As described above, in a case where there is a high possibility that the same supply state is continuous, when the supply state is appropriate for first component 81, the supply state determination is not required for second component 82. As a result, component mounter 10 of the present embodiment can simplify the supply state determination of component 80. In a case where first determination section 41 determines that the supply state of first component 81 is inappropriate (case of NO in Step S12), it is preferable that second determination section 42 determines that the supply state determination is required for second component 82 (Step S14). In this case, control device 16 also executes the supply state determination of second component 82, and confirms the supply state of second component 82.

### 1-3-3. Timing Setting Section 43

Timing setting section 43 sets the operation start timing at which holding member 30 that picks up and holds component 80 and mounts component 80 on board 90 starts a lowering operation to pick up component 80 for both first component 81 and second component 82. Specifically, it is preferable that timing setting section 43 sets first timing TG1 for first component 81. In addition, it is preferable that timing setting section 43 sets second timing TG2 for second component 82 when first determination section 41 determines that the supply state of first component 81 is appropriate (Step S15). However, it is assumed that imaging position PC1 of component 80 when component 80 is imaged coincides with picking up position PP1 of component 80 when component 80 is picked up.

First timing TG1 is an operation start timing at which the lowering operation of holding member 30 is started after component 80 is positioned at picking up position PP1. Second timing TG2 is an operation start timing which is set at least earlier than first timing TG1 by required time ΔT from when holding member 30 starts the lowering operation to when holding member 30 reaches component 80. Fig. 6A illustrates an example of first timing TG1. Time T11 indicates the time at which component 80 is positioned at picking up position PP1. Time T12 indicates a time at which the lowering operation of holding member 30 is started. Time T13 indicates a time at which holding member 30 reaches component 80. In this case, required time ΔT is a time from time T12 to time T13.

As described above, first determination section 41 executes the supply state determination for first component 81. Therefore, imaging of first component 81 is required, and it is required to start the lowering operation of holding member 30 after first component 81 is positioned at picking up position PP1. Therefore, timing setting section 43 sets first timing TG1 for first component 81. As a result, the lowering operation of holding member 30 is started at time T12, and holding member 30 reaches component 80 at time T13.

Fig. 6B illustrates an example of second timing TG2. Time T21 indicates a time at which the lowering operation of holding member 30 is started. Time T11 is the same as time T11 in Fig. 6A, and indicates a time at which component 80 is positioned at picking up position PP1. When first determination section 41 determines that the supply state of first component 81 is appropriate, second determination section 42 determines that the supply state determination is not required for second component 82. In this case, imaging of second component 82 is not required, and the lowering operation of holding member 30 can be started before second component 82 is positioned at picking up position PP1. Therefore, timing setting section 43 sets second timing TG2 for second component 82. As a result, the lowering operation of holding member 30 is started at time T21, and holding member 30 reaches component 80 at time T11. As a result, component mounter 10 of the present embodiment can reduce the cycle time.

When holding member 30 reaches the planned arrival position before second component 82 is positioned at picking up position PP1, second component 82 and holding member 30 may interfere with each other, and holding member 30 may fail to pick up second component 82. Therefore, as illustrated in Fig. 6B, it is preferable that second timing TG2 is set so that holding member 30 reaches component 80 in accordance with the timing at which component 80 is positioned at picking up position PP1. In this case, component mounter 10 can minimize the cycle time.

In addition, it is preferable that timing setting section 43 sets first timing TG1 for second component 82 when first determination section 41 determines that the supply state of first component 81 is inappropriate (Step S16). That is, timing setting section 43 sets first timing TG1 for both first component 81 and second component 82. However, it is assumed that imaging position PC1 of component 80 when component 80 is imaged coincides with picking up position PP1 of component 80 when component 80 is picked up.

When first determination section 41 determines that the supply state of first component 81 is inappropriate, second determination section 42 determines that the supply state determination is required for second component 82. In this case, imaging of second component 82 is required, and it is required to start the lowering operation of holding member 30 after second component 82 is positioned at picking up position PP1. Therefore, timing setting section 43 sets first timing TG1 for second component 82. As a result, the lowering operation of holding member 30 is started at time T12, and holding member 30 reaches component 80 at time T13.

### 1-3-4. Holding Member Control Section 44

The operation start timing set by timing setting section 43 is transmitted to component supply device 12. Component supply device 12 transmits a completion notification indicating that component 80 is positioned at picking up position PP1 to holding member control section 44 based on the operation start timing set by timing setting section 43.

For example, in a case where component supply device 12 is provided with multiple feeders 121, each of multiple feeders 121 is provided with a sprocket, a driving device for rotationally driving the sprocket, and a position detector for detecting the rotational position of the sprocket (both not illustrated). The sprocket pitch-feeds a carrier tape storing multiple components 80. For example, as the driving device, a positionable electric motor such as a stepping motor or a servo motor can be used. In a case where the operation start timing is set to first timing TG1, component supply device 12 transmits a completion notification after component 80 is actually positioned at picking up position PP1. For example, component supply device 12 can obtain that component 80 is positioned at picking up position PP1 by the detection value of the position detector.

In a case where the operation start timing is set to second timing TG2, component supply device 12 can transmit a completion notification before component 80 is positioned at picking up position PP1. For example, component supply device 12 can obtain the timing of transmitting the completion notification by the command to the driving device (number of pulses of pulse signal to be transmitted to stepping motor and position command to be transmitted to servo motor) and the detection value (current position) of the position detector.

Holding member control section 44 controls holding member 30. When the completion notification is received from component supply device 12, holding member control section 44 starts the lowering operation of holding member 30. Specifically, holding member control section 44 determines whether the completion notification is received from component supply device 12 (Step S21 illustrated in Fig. 4B). In a case where the completion notification is received (case of Yes in Step S21), holding member control section 44 drives Z-axis motor 27 illustrated in Fig. 2, to move tool shaft 24 and holding member 30 downward in the Z-axis direction. As a result, the lowering operation of holding member 30 is started in Step S22. In a case where the completion notification is not received (case of NO in Step S21), the control returns to the determination in Step S21, and holding member control section 44 waits until the completion notification is received.

Next, holding member control section 44 determines whether the picking up of all components 80 (first component 81 and second component 82) to be mounted on board 90 is completed (Step S23). In a case where the picking up of all components 80 is completed (case of Yes in Step S23), the control is temporarily ended. In a case where the picking up of all components 80 is not completed (case of NO in Step S23), the control returns to the determination in Step S21, and holding member control section 44 determines whether the completion notification is received from component supply device 12.

In this manner, holding member 30 can start the lowering operation for picking up component 80 at the operation start timing set by timing setting section 43. It takes a predetermined time until component supply device 12 detects that component 80 is positioned at picking up position PP1, transmits the completion notification, and holding member control section 44 receives the completion notification. In addition, it takes a predetermined time from the time when holding member control section 44 transmits a command for driving Z-axis motor 27 until the lowering operation of holding member 30 is actually started. The time from time T11 to time T12 illustrated in Fig. 6A includes these predetermined times.

In addition, it is preferable that holding member control section 44 corrects the position and angle of holding member 30 and mounts first component 81 on board 90, based on the posture of first component 81 in holding member 30 obtained by image processing the captured image obtained by imaging first component 81 held by holding member 30. Specifically, for example, holding member control section 44 images first component 81 held by holding member 30 using part camera 14 illustrated in Fig. 1. Holding member control section 44 acquires the posture of first component 81 in holding member 30 by image processing the captured image captured by part camera 14. Holding member control section 44 corrects the position and angle of holding member 30 based on the posture of first component 81 and mounts first component 81 on board 90.

As illustrated in Fig. 5, it is assumed that first component 81 is held by holding member 30 in a state of being rotated counterclockwise by an angle of θ1, at a position moved from center position 81a of first component 81 in a direction opposite to the X-axis direction (negative direction of the X-axis) by a deviation ΔX. In this case, holding member control section 44 sets the position moved in a direction opposite to the X-axis direction (negative direction of the X-axis) by a deviation ΔX with respect to the planned mounting position determined by the control program, mounting conditions, and the like as the mounting position of first component 81 and the target position of holding member 30. In addition, holding member control section 44 sets the correction rotation angle of holding member 30 to an angle θ1 (clockwise). The above description for first component 81 can be similarly said for second component 82.

As described above, first determination section 41 can acquire the position and the angle of first component 81 when first component 81 is positioned at imaging position PC1 (picking up position PP1) based on outer shape 81s and center position 81a of first component 81 obtained by image processing the captured image obtained by imaging first component 81. The positioning accuracy of holding member 30 when holding member control section 44 corrects the position and angle of holding member 30 is required to be higher than the positioning accuracy of first component 81 when first determination section 41 executes the supply state determination for first component 81. Component mounter 10 of the present embodiment can position first component 81 and holding member 30 in response to the required positioning accuracy.

### 1-3-5. Initialization Section 45

Initialization section 45 causes first determination section 41, second determination section 42, and timing setting section 43 to execute processing on component 80 supplied from exchanged component supply device 12 when component supply device 12 supplying second component 82 is exchanged, or when an exchange of component supply device 12 is predicted.

When component supply device 12 that supplies second component 82 (for example, feeder 121) is exchanged, first determination section 41 may execute the supply state determination for first component 81 supplied from exchanged component supply device 12. In addition, second determination section 42 may determine the necessity of the supply state determination for second component 82 supplied from exchanged component supply device 12. Furthermore, timing setting section 43 may set the operation start timing for both first component 81 and second component 82 supplied from exchanged component supply device 12.

In addition, component supply device 12 (for example, feeder 121) may be provided with multiple component storage sections (for example, tape reel around which a carrier tape is wound). In this case, component supply device 12 can supply component 80 from a second component storage section (tape reel), after component 80 are supplied from a first component storage section (tape reel). For example, timing of supplying component 80 from the second component storage section (tape reel) can be predicted by counting the number of components 80 supplied from the first component storage section (tape reel). As described above, similarly, when it is predicted that component supply device 12 (component storage section) supplying second component 82 is exchanged, first determination section 41, second determination section 42, and timing setting section 43 may execute the determination and processing described above.

Initialization section 45 determines whether the supply of component 80 from exchanged component supply device 12 is started (Step S31 illustrated in Fig. 4C). For example, initialization section 45 can determine whether component supply device 12 is exchanged by the difference between the identification code of component supply device 12 before the exchange (for example, feeder 121) and the identification code of exchanged component supply device 12 (for example, feeder 121). In addition, initialization section 45 can also obtain the exchange timing of component supply device 12, for example, according to a production plan or the like. Furthermore, as described above, initialization section 45 can obtain the exchange timing of component supply device 12 (component storage section (tape reel)) by counting the number of components of component 80.

In a case where the supply of component 80 from exchanged component supply device 12 is started (case of Yes in Step S31), initialization section 45 executes initialization processing (Step S32). Specifically, initialization section 45 causes first determination section 41 to execute the above-described determination on first component 81 supplied from exchanged component supply device 12. In addition, initialization section 45 causes second determination section 42 to execute the above-described determination on second component 82 supplied from exchanged component supply device 12. Furthermore, initialization section 45 causes timing setting section 43 to set the operation start timing for both first component 81 and second component 82 supplied from exchanged component supply device 12. In a case where the supply of component 80 supplied from exchanged component supply device 12 is not started (case of NO in Step S31), the control is temporarily ended.

### 2. Modification Aspect

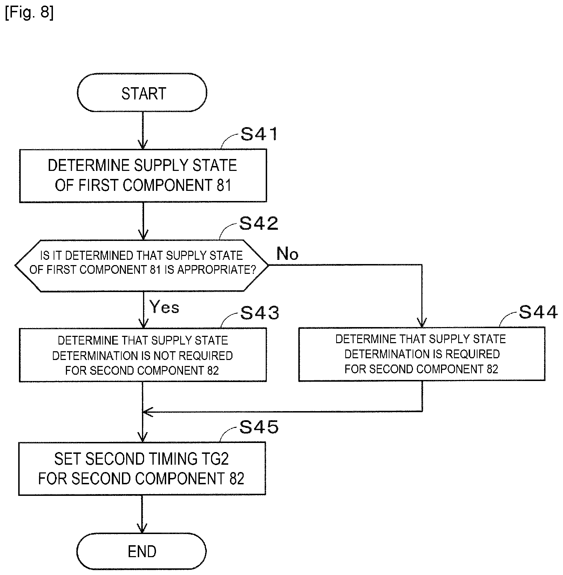

Imaging position PC1 of component 80 when component 80 is imaged and picking up position PP1 of component 80 when component 80 is picked up may be different from each other. Fig. 7 illustrates an example of component supply device 12 (for example, feeder 121) in which imaging position PC1 and picking up position PP1 are different from each other. Fig. 8 illustrates an example of a control procedure by first determination section 41, second determination section 42, and timing setting section 43 in this case.

Processing illustrated in Step S41 in Fig. 8 corresponds to the processing illustrated in Step S11 in Fig. 4A. A determination in Step S42 corresponds to the determination in Step S12. Processing illustrated in Step S43 corresponds to the processing illustrated in Step S13. Processing illustrated in Step S44 corresponds to the processing illustrated in Step S14. Processing illustrated in Step S45 corresponds to the processing illustrated in Step S15. In addition, the control illustrated in Fig. 8 executes the processing illustrated in Step S45 (processing corresponding to Step S15), instead of the processing illustrated in Step S16 in Fig. 4A.

As illustrated in Fig. 7, for example, it is assumed that picking up position PP1 of component 80 is separated from irradiation range RA1 of the light source used when imaging component 80 by predetermined distance L1 or more. Predetermined distance L1 is the largest range capable of imaging component 80 using the light source, for example, can be represented by a distance starting from the center of irradiation range RA1. Predetermined distance L1 can be set in advance based on the type of component 80, the imaging conditions (for example, the amount of light of the light source, irradiation angle, light exposure time, and aperture), and the like. In component mounter 10 of the present embodiment, an attachment position of the light source used when imaging component 80 is not limited by picking up position PP1.

In the present embodiment, component 80 cannot be imaged at picking up position PP1 of component 80. Therefore, when executing the supply state determination of component 80, it is required to image component 80 at a position different from picking up position PP1. In this case, control device 16 positions component 80 at imaging position PC1 different from picking up position PP1 with respect to component supply device 12. In the same manner as in the case where imaging position PC1 and picking up position PP1 are the same as each other, first determination section 41 executes the supply state determination for first component 81 (Step S41). When it is determined by first determination section 41 that the supply state of first component 81 is appropriate (case of Yes in Step S42), it is preferable that second determination section 42 determines that the supply state determination is not required for second component 82 (Step S43). In addition, when first determination section 41 determines that the supply state of first component 81 is inappropriate (case of NO in Step S42), it is preferable that second determination section 42 determines that the supply state determination is required for second component 82 (Step S44).

Control device 16 positions component 80 at picking up position PP1 for component supply device 12, after imaging of component 80 is completed. Since component 80 is not imaged at picking up position PP1, timing setting section 43 sets second timing TG2 for both first component 81 and second component 82 (Step S45), regardless of the suitability of the supply state of first component 81 determined by first determination section 41. Control device 16 can also advance component 80 after temporarily moving component 80 from imaging position PC1 to retreat position PB1 for component supply device 12 to position component 80 at picking up position PP1. AS a result, component mounter 10 can reduce the positioning error due to backlash.

### 3. Others

Component supply device 12 (for example, feeder 121) may sequentially supply components 80 to be mounted on board 90, and is not limited to a device that supplies the same type of components 80 manufactured in the same lot of the same manufacturer. In addition, multiple types of components 80 are normally mounted on board 90. In this case, component supply device 12 can supply multiple types of components 80, and it can be said that each of multiple feeders 121 that supply multiple types of components 80 is described in the present specification.

Furthermore, first components 81 may be a predetermined number of components 80 which is smaller than the number of components 80 supplied from component supply device 12 to board 90, and is not limited to first component 80 first supplied from component supply device 12. For example, first determination section 41 may execute the supply state determination for components 80 of several pieces (for example, two pieces to five pieces) supplied from component supply device 12. As a result, first determination section 41 can also confirm the continuity of the supply state of component 80.

In addition, the arrangement of component supply device 12 may take various aspects. For example, two component supply device 12 may be component mounter 10 disposed to face each other across board conveyance device 11. In this case, board conveyance device 11 may be provided for each of two component supply device 12, and one board conveyance device 11 may be provided for two component supply device 12.

### 4. Component Picking Up Method

The above description for component mounter 10 can be similarly said for the component picking up method. Specifically, the component picking up method is applied to component mounter 10 provided with component supply device 12 for sequentially supplying component 80 to be mounted on board 90. The component picking up method is provided with a first determination step, a second determination step, and a timing setting step. The first determination step corresponds to the control executed by first determination section 41. The second determination step corresponds to the control executed by second determination section 42. The timing setting step corresponds to the control executed by timing setting section 43. In addition, it is preferable that the component picking up method is provided with at least one of a holding member control step and an initialization step. The holding member control step corresponds to the control executed by holding member control section 44. The initialization step corresponds to the control executed by initialization section 45.

### 5. Example of Effect of Embodiment

According to component mounter 10, first determination section 41, second determination section 42, and timing setting section 43 are provided. As a result, component mounter 10 can determine the necessity of the supply state determination for second component 82 based on the result of determination by first determination section 41. In addition, component mounter 10 can also set the operation start timing for both first component 81 and second component 82. The above description for component mounter 10 can be similarly said for the component picking up method.

### Reference Signs List

10: component mounter, 12: component supply device, 30: holding member, 41: first determination section, 42: second determination section, 43: timing setting section, 44: holding member control section, 45: initialization section, 80: component, 81: first component, 82: second component, 90: board, PC1: imaging position, PP1: picking up position, TG1: first timing, TG2: second timing, ΔT: required time, RA1: irradiation range, L1: predetermined distance, 81s: outer shape, 81a: center position

## Claims

1. A component mounter comprising:
a component supply device (12) configured to sequentially supply components (80, 81, 82) to be mounted on a board (90);
an imaging device (14, 15); and
a first determination section (41) configured to execute a supply state determination (S11) by imaging the component (81) by using the imaging device (14, 15) before the component (80, 81, 82) is picked up at a picking up position (PP1);
**characterized in that**
the first determination section (41) is configured to determine (S12) whether a supply state of the component (80, 81, 82) in the component supply device (12) is appropriate for first components (81) which are a predetermined number of the components (80, 81, 82) smaller than the number of the components (80, 81, 82) supplied from the component supply device (12) to the board (90), wherein
the first determination section (41) determines (S12) that the supply state of the first component (81) is appropriate when both a position and an angle of the first component (81), when the first component (81) is positioned at an imaging position (PC1), are included in a predetermined range; and
the component mounter comprises
a second determination section (42) configured to determine (S13, S14) necessity of the supply state determination for a second component (82) which is the component (80, 81, 82) supplied from the component supply device (12) after the first component (81) is supplied, based on a result of determination (S12) by the first determination section (41); and
a timing setting section (43) configured to set (S15, S16) an operation start timing (TG1, TG2), at which a holding member (30), picking up and hold the component to mount the component (80, 81, 82) on the board (90), starts a lowering operation for picking up the component (80, 81, 82), for both of the first component (81) and the second component (82), wherein
an imaging position (PC1) of the component (80, 81, 82) when the component (80, 81, 82) is imaged, and the picking up position (PP1) of the component (80, 81, 82) when the component (80, 81, 82) is picked up coincide with each other, and
when the operation start timing at which the lowering operation of the holding member (30) is started after the component (80, 81, 82) is positioned at the picking up position (PP1) is defined as a first timing (TG1), and the operation start timing which is set earlier than at least the first timing (TG1) by a required time from when the holding member (30) starts the lowering operation to when the holding member (30) reaches the component (80, 81, 82) is defined as a second timing (TG2),
the second determination section (42) is configured to determine (S13) that the supply state determination is not required for the second component (82), when it is determined that (S12) a supply state of the first component (81) is appropriate by the first determination section (41), and
the timing setting section (43) is configured to set the first timing (TG1) for the first component (81) and sets (S15) the second timing (TG2) for the second component (82).

2. The component mounter according to claim 1, wherein
an imaging position (PC1) of the component (80, 81, 82) when the component (80, 81, 82) is imaged, and the picking up position (PP1) of the component (80, 81, 82) when the component (80) is picked up coincide with each other, and
when the operation start timing at which the lowering operation of the holding member (30) is started after the component (80, 81, 82) is positioned at the picking up position (PP1) is defined as a first timing (TG1),
the second determination section (42) is configured to determine (S14) that the supply state determination is required for the second component (82), when it is determined (S12) that a supply state of the first component (81) is inappropriate by the first determination section (41), and
the timing setting section (43) is configured to set (S16) the first timing (TG1) for both the first component (81) and the second component (82).

3. The component mounter according to claim 1 or 2, further comprising:
an initialization section (45) configured to cause the first determination section (41), the second determination section (42), and the timing setting section (43) to execute processing on the component supplied from the exchanged component supply device (12) when the component supply device (12) supplying the second component (82) is exchanged or when an exchange of the component supply device (12) is predicted.

4. The component mounter according to any one of claims 1 to 3, further comprising:
a holding member control section (44) configured to control the holding member (30), wherein
the component supply device (12) is configured to transmit a completion notification indicating that the component (80, 81, 82) is positioned at the picking up position (PP1) to the holding member control section (44) based on the operation start timing set by the timing setting section (43), and
the holding member control section (44) is configured to start the lowering operation of the holding member (30), when the holding member control section (44) receives the completion notification from the component supply device (12).

5. The component mounter according to any one of claims 1 to 4, wherein
the first determination section (41) is configured to determine (S12) that the supply state of the first component (81) is inappropriate when at least one of the position and the angle of the first component (81) when the first component (81) is positioned at the imaging position (PC1) is not included in the predetermined range.

6. The component mounter according to claim 5, further comprising:
a holding member control section (44) configured to control the holding member (30), wherein
the first determination section (41) is configured to acquire the position and the angle of the first component (81) when the first component (81) is positioned at the imaging position (PC1), based on an outer shape and center position of the first component (81) obtained by image processing a captured image obtained by imaging the first component (81), and
the holding member control section (44) is configured to correct a position and an angle of the holding member (30) and to mount the first component (81) on the board (90), based on a posture of the first component (81) in the holding member (30) obtained by image processing the captured image obtained by imaging the first component (81) held by the holding member (30).

7. The component mounter according to any one of claims 1 to 6, wherein
the component supply device (12) is configured to supply the same type of the component (80, 81, 82) manufactured in the same lot of the same manufacturer.

8. The component mounter according to any one of claims 1 to 7, wherein
the first component (81) is a first component (81) supplied first from the component supply device (12).

9. A component picking up method applied to a component mounter (10) including a component supply device (12) configured to sequentially supply components (80, 81, 82) to be mounted on a board (90), the method comprising:
a first determination step of executing a supply state determination (S11) by imaging the component (80, 81, 82) by using an imaging device (14, 15) before the component (80, 81, 82) is picked up at a picking up position (PP1);
**characterized by**
determining (S12) whether a supply state of the component (80, 81, 82) in the component supply device (12) is appropriate for first components (81) which are a predetermined number of the components (80, 81, 82) smaller than the number of the components (80, 81, 82) supplied from the component supply device (12) to the board (90), wherein
it is determined (S12) that the supply state of the first component (81) is appropriate when both a position and an angle of the first component (81), when the first component (81) is positioned at an imaging position (PC1), are included in a predetermined range;
a second determination step (S13, S14) of determining necessity of the supply state determination for a second component (82) which is the component (80, 81, 82) supplied from the component supply device (12) after the first component (81) is supplied, based on a result of determination by the first determination step (S12); and
a timing setting step (S15, S16) of setting an operation start timing, at which a holding member (30), picking up and hold the component (80, 81, 82) to mount the component (80, 81, 82) on the board (90), starts a lowering operation for picking up the component (80, 81, 82), for both of the first component (81) and the second component (82), wherein
an imaging position (PC1) of the component (80, 81, 82) when the component (80, 81, 82) is imaged, and the picking up position (PP1) of the component (80, 81, 82) when the component (80, 81, 82) is picked up coincide with each other, and
when the operation start timing at which the lowering operation of the holding member (30) is started after the component (80, 81, 82) is positioned at the picking up position (PP1) is defined as a first timing (TG1), and the operation start timing which is set earlier than at least the first timing (TG1) by a required time from when the holding member (30) starts the lowering operation to when the holding member (30) reaches the component (80, 81, 82) is defined as a second timing (TG2),
it is determined (S13) that the supply state determination is not required for the second component (82), when it is determined that (S12) a supply state of the first component (81) is appropriate, and
the first timing (TG1) is set for the first component (81) and the second timing (TG2) is set (S15) for the second component (82).

## Patentansprüche

1. Bauteil-Montagevorrichtung, die umfasst:
eine Bauteil-Zuführeinrichtung (12), die so ausgeführt ist, dass sie sequenziell auf einer Platine (90) zu montierende Bauteile (80, 81, 82) zuführt;
eine Bilderzeugungseinrichtung (14, 15); sowie
einen ersten Feststellungs-Teilabschnitt (41), der so ausgeführt ist, dass er eine Feststellung (S11) bezüglich eines Zuführ-Zustandes ausführt, indem er ein Bild des Bauteils (81) unter Einsatz der Bilderzeugungseinrichtung (14, 15) erzeugt, bevor das Bauteil (80, 81, 82) an einer Aufnahmeposition (PP1) aufgenommen wird;
**dadurch gekennzeichnet, dass**
der erste Feststellungs-Teilabschnitt (41) so ausgeführt ist, dass er feststellt, (S12), ob ein Zuführ-Zustand des Bauteils (80, 81, 82) in der Bauteil-Zuführeinrichtung (12) für erste Bauteile (81) geeignet ist, die eine vorgegebene Anzahl der Bauteile (80, 81, 82) sind, die kleiner ist als die Anzahl der Bauteile (80, 81, 82), die von der Bauteil-Zuführeinrichtung (12) zu der Platine (90) zugeführt werden, wobei der erste Feststellungs-Teilabschnitt (41) feststellt (S12), dass der Zuführ-Zustand des ersten Bauteils (81) geeignet ist, wenn sowohl eine Position als auch ein Winkel des ersten Bauteils (81) in einem vorgegebenen Bereich eingeschlossen sind, wenn sich das erste Bauteil (81) an einer Bilderzeugungsposition (PC1) befindet; und
die Bauteil-Montagevorrichtung umfasst:
einen zweiten Feststellungs-Teilabschnitt (42), der so ausgeführt ist, dass er auf Basis eines Ergebnisses von Feststellung (S12) durch den ersten Feststellungs-Teilabschnitt (41) Notwendigkeit der Feststellung des Zuführ-Zustandes für ein zweites Bauteil (82) feststellt (S13, S14), bei dem es sich um das Bauteil (80, 81, 82) handelt, das von der Bauteil-Zuführeinrichtung (12) nach Zuführen des ersten Bauteils (81) zugeführt wird; sowie
einen Zeiteinstellungs-Teilabschnitt (43), der so ausgeführt ist, dass er einen Anfangszeitpunkt (TG1, TG2) für einen Vorgang (S15, S16), zu dem ein Halteelement (30), das das Bauteil aufnimmt und hält, um das Bauteil (80, 81, 82) auf der Platine (90) zu montieren, einen Absenkvorgang zum Aufnehmen des Bauteils (80, 81, 82) beginnt, sowohl für das erste Bauteil (81) als auch für das zweite Bauteil (82) einstellt, wobei eine Bilderzeugungsposition (PC1) des Bauteils (80, 81, 82) beim Erzeugen eines Bildes des Bauteils (80, 81, 82) und die Aufnahmeposition (PP1) des Bauteils (80, 81, 82) beim Aufnehmen des Bauteils (80, 81, 82) miteinander übereinstimmen,
der zweite Feststellungs-Teilabschnitt (42) so ausgeführt ist, dass er, wenn der Anfangszeitpunkt für einen Vorgang, zu dem mit dem Absenkvorgang des Halteelementes (30) begonnen wird, nachdem das Bauteil (80, 81, 82) an die Aufnahmeposition (PP1) gebracht ist, als ein erster Zeitpunkt (TG1) definiert ist, und der Anfangszeitpunkt für einen Vorgang, der um eine erforderliche Zeit von dem Zeitpunkt, zu dem das Halteelement (30) den Absenkvorgang beginnt, bis zu dem Zeitpunkt, zu dem das Halteelement (30) das Bauteil (80, 81, 82) erreicht, früher eingestellt wird als wenigstens der erste Zeitpunkt (TG1), als ein zweiter Zeitpunkt (TG2) definiert ist, feststellt, dass die Feststellung des Zuführ-Zustandes für das zweite Bauteil (82) nicht erforderlich ist, wenn durch den ersten Feststellungs-Teilabschnitt (41) festgestellt wird (S12), dass ein Zuführ-Zustand des ersten Bauteils (81) geeignet ist, und
der Zeiteinstellungs-Teilabschnitt (43) so ausgeführt ist, dass er den ersten Zeitpunkt (TG1) für das erste Bauteil (81) einstellt und den zweiten Zeitpunkt (TG2) für das zweite Bauteil (82) einstellt (S15).

2. Bauteil-Montagevorrichtung nach Anspruch 1, wobei
eine Bilderzeugungsposition (PC1) des Bauteils (80, 81, 82) beim Erzeugen eines Bildes des Bauteils (80, 81, 82) und die Aufnahmeposition (PP1) des Bauteils (80, 81, 82) beim Aufnehmen des Bauteils (80, 81, 82) miteinander übereinstimmen,
der zweite Feststellungs-Teilabschnitt (42) so ausgeführt ist, dass er, wenn der Anfangszeitpunkt für einen Vorgang, zu dem mit dem Absenkvorgang des Halteelementes (30) begonnen wird, nachdem das Bauteil (80, 81, 82) an die Aufnahmeposition (PP1) gebracht ist, als ein erster Zeitpunkt (TG1) definiert ist, feststellt, dass die Feststellung des Zuführ-Zustandes für das zweite Bauteil (82) erforderlich ist, wenn durch den ersten Feststellungs-Teilabschnitt (41) festgestellt wird (S12), dass ein Zuführ-Zustand des ersten Bauteils (81) ungeeignet ist, und
der Zeiteinstellungs-Teilabschnitt (43) so ausgeführt ist, dass er den ersten Zeitpunkt (TG1) sowohl für das erste Bauteil (81) als auch für das zweite Bauteil (82) einstellt (S16).

3. Bauteil-Montagevorrichtung nach Anspruch 1 oder 2, die des Weiteren umfasst:
einen Initialisierungs-Teilabschnitt (45), der so ausgeführt ist, dass er veranlasst, dass der erste Feststellungs-Teilabschnitt (41), der zweite Feststellungs-Teilabschnitt (42) und der Zeiteinstellungs-Teilabschnitt (43) Verarbeitung an dem von der ausgetauschten Bauteil-Zuführeinrichtung (12) zugeführten Bauteil ausführen, wenn die Bauteil-Zuführeinrichtung (12), die das zweite Bauteil (82) zuführt, ausgetauscht wird oder wenn ein Austausch der Bauteil-Zuführeinrichtung (12) vorhergesagt wird.

4. Bauteil-Montagevorrichtung nach einem der Ansprüche 1 bis 3, die des Weiteren umfasst:
einen Halteelement-Steuerungsabschnitt (44), der zum Steuern des Halteelementes (30) ausgeführt ist, wobei
die Bauteil-Zuführeinrichtung (12) so ausgeführt ist, dass sie eine Abschluss-Benachrichtigung, die anzeigt, dass das Bauteil (80, 81, 82) an die Aufnahmeposition (PP1) gebracht ist, auf Basis des durch den Zeiteinstellungs-Teilabschnitt (43) eingestellten Anfangszeitpunktes für einen Vorgang zu dem Halteelement-Steuerungsabschnitt (44) sendet, und
der Halteelement-Steuerungsabschnitt (44) so ausgeführt ist, dass er den Absenkvorgang des Halteelementes (30) beginnt, wenn der Halteelement-Steuerungsabschnitt (44) die Abschluss-Benachrichtigung von der Bauteil-Zuführeinrichtung (12) empfängt.

5. Bauteil-Montagevorrichtung nach einem der Ansprüche 1 bis 4, wobei
der erste Feststellungs-Teilabschnitt (41) so ausgeführt ist, dass er feststellt (S12), dass der Zuführ-Zustand des ersten Bauteils (81) ungeeignet ist, wenn die Position oder/und der Winkel des ersten Bauteils (81), wenn sich das erste Bauteil (81) an der Bilderzeugungsposition (PC1) befindet, nicht in dem vorgegebenen Bereich eingeschlossen ist/sind.

6. Bauteil-Montagevorrichtung nach Anspruch 5, die des Weiteren umfasst:
einen Halteelement-Steuerungsabschnitt (44), der zum Steuern des Halteelementes (30) ausgeführt ist, wobei
der erste Feststellungs-Teilabschnitt (41) so ausgeführt ist, dass er, wenn sich das erste Bauteil (81) an der Bilderzeugungsposition (PC1) befindet, die Position und den Winkel des ersten Bauteils (81) auf Basis einer äußeren Form und einer Mittelposition des ersten Bauteils (81) erfasst, die mittels Bildverarbeitung eines aufgenommenen Bildes ermittelt werden, das durch Erzeugen eines Bildes des ersten Bauteils (81) gewonnen wird, und
der Halteelement-Steuerungsabschnitt (44) so ausgeführt ist, dass er eine Position sowie einen Winkel des Halteelementes (30) korrigiert, und das erste Bauteil (81) auf Basis einer Stellung des ersten Bauteils (81) in dem Halteelement (30) montiert, die mittels Bildverarbeitung des aufgenommenen Bildes ermittelt wird, das durch Erzeugen eines Bildes des von dem Halteelement (30) gehaltenen ersten Bauteils (81) gewonnen wird.

7. Bauteil-Montagevorrichtung nach einem der Ansprüche 1 bis 6, wobei
die Bauteil-Zuführeinrichtung (12) so ausgeführt ist, dass sie den in der gleichen Charge des gleichen Herstellers hergestellten gleichen Typ des Bauteils (80, 81, 82) zuführt.

8. Bauteil-Montagevorrichtung nach einem der Ansprüche 1 bis 7, wobei
das erste Bauteil (81) ein erstes Bauteil (81) ist, das zuerst von der Bauteil-Zuführeinrichtung (12) zugeführt wird.

9. Verfahren zum Aufnehmen von Bauteilen, angewendet bei einer Bauteil-Montagevorrichtung (10), die eine Bauteil-Zuführeinrichtung (12) enthält, die so ausgeführt ist, dass sie sequenziell auf einer Platine (90) zu montierende Bauteile (80, 81, 82) zuführt, wobei das Verfahren umfasst:
einen ersten Feststellungs-Schritt, in dem eine Feststellung bezüglich eines Zuführ-Zustandes ausgeführt wird (S11), indem ein Bild des Bauteils (80, 81, 82) unter Einsatz einer Bilderzeugungseinrichtung (14, 15) erzeugt wird, bevor das Bauteil (80, 81, 82) an einer Aufnahmeposition (PP1) aufgenommen wird;
**gekennzeichnet durch**
Feststellen (S12), ob ein Zuführ-Zustand des Bauteils (80, 81, 82) in der Bauteil-Zuführeinrichtung (12) für erste Bauteile (81) geeignet ist, die eine vorgegebene Anzahl der Bauteile (80, 81, 82) sind, die kleiner ist als die Anzahl der Bauteile (80, 81, 82), die von der Bauteil-Zuführeinrichtung (12) zu der Platine (90) zugeführt werden, wobei
festgestellt wird (S12), dass der Zuführ-Zustand des ersten Bauteils (81) geeignet ist, wenn sowohl eine Position als auch ein Winkel des ersten Bauteils (81) in einem vorgegebenen Bereich eingeschlossen sind, wenn sich das erste Bauteil (81) an einer Bilderzeugungsposition (PC1) befindet; und
einen zweiten Feststellungs-Schritt (S13, S14), in dem auf Basis eines Ergebnisses von Feststellung (S12) durch den ersten Feststellungs-Schritt (S12) Notwendigkeit der Feststellung bezüglich des Zuführ-Zustandes für ein zweites Bauteil (82) festgestellt wird, bei dem es sich um das Bauteil (80, 81, 82) handelt, das von der Bauteil-Zuführeinrichtung (12) nach Zuführen des ersten Bauteils (81) zugeführt wird; und
einen Zeiteinstellungs-Schritt (S15, S16), in dem ein Anfangszeitpunkt für einen Vorgang, zu dem ein Halteelement (30), das das Bauteil (80, 81, 82) aufnimmt und hält, um das Bauteil (80, 81, 82) auf der Platine (90) zu montieren, einen Absenkvorgang zum Aufnehmen des Bauteils (80, 81, 82) beginnt, sowohl für das erste Bauteil (81) als auch für das zweite Bauteil (82) eingestellt wird, wobei
eine Bilderzeugungsposition (PC1) des Bauteils (80, 81, 82) beim Erzeugen eines Bildes des Bauteils (80, 81, 82) und die Aufnahmeposition (PP1) des Bauteils (80, 81, 82) beim Aufnehmen des Bauteils (80, 81, 82) miteinander übereinstimmen, und
wenn der Anfangszeitpunkt für einen Vorgang, zu dem mit dem Absenkvorgang des Halteelementes (30) begonnen wird, nachdem das Bauteil (80, 81, 82) an die Aufnahmeposition (PP1) gebracht ist, als ein erster Zeitpunkt (TG1) definiert ist, und der Anfangszeitpunkt für einen Vorgang, der um eine erforderliche Zeit von dem Zeitpunkt, zu dem das Halteelement (30) den Absenkvorgang beginnt, bis zu dem Zeitpunkt, zu dem das Halteelement (30) das Bauteil (80, 81, 82) erreicht, früher eingestellt wird als wenigstens der erste Zeitpunkt (TG1), als ein zweiter Zeitpunkt (TG2) definiert ist,
festgestellt wird (S13), dass die Feststellung hinsichtlich des Zuführungs-Zustandes für das zweite Bauteil (82) nicht erforderlich ist, wenn festgestellt wird (S12), dass ein Zuführungs-Zustand des ersten Bauteils (81) geeignet ist, und
der erste Zeitpunkt (TG1) für das erste Bauteil (81) eingestellt wird und der zweite Zeitpunkt (TG2) für das zweite Bauteil (82) eingestellt wird (S15).

## Revendications

1. Monteur de composants comprenant :
un dispositif d'alimentation en composants (12) configuré pour fournir séquentiellement des composants (80, 81, 82) à monter sur une carte (90) ;
un dispositif d'imagerie (14, 15) ; et
une première section de détermination (41) configurée pour exécuter une détermination de l'état d'alimentation (S11) par imagerie du composant (81) à l'aide du dispositif d'imagerie (14, 15) avant que le composant (80, 81, 82) ne soit prélevé à une position de prélèvement (PP1) ;
**caractérisé en ce que**
la première section de détermination (41) est configurée pour déterminer (S12) si un état d'alimentation du composant (80, 81, 82) dans le dispositif d'alimentation en composants (12) est approprié pour les premiers composants (81) qui sont un nombre prédéterminé de composants (80, 81, 82) plus petit que le nombre de composants (80, 81, 82) fournis par le dispositif d'alimentation en composants (12) à la carte (90), dans lequel
la première section de détermination (41) détermine (S12) que l'état d'alimentation du premier composant (81) est approprié lorsqu'une position et un angle du premier composant (81), lorsque le premier composant (81) est positionné à une position d'imagerie (PC1), sont compris dans une plage prédéterminée ; et
le monteur de composants comprend
une deuxième section de détermination (42) configurée pour déterminer (S13, S14) la nécessité de la détermination de l'état d'alimentation pour un deuxième composant (82) qui est le composant (80, 81, 82) fourni par le dispositif d'alimentation en composants (12) après que le premier composant (81) a été fourni, sur la base d'un résultat de la détermination (S12) par la première section de détermination (41) ; et
une section de réglage du temps (43) configurée pour régler (S15, S16) un temps de début d'opération (TG1, TG2), auquel un élément de maintien (30), saisissant et maintenant le composant pour monter le composant (80, 81, 82) sur la carte (90), commence une opération d'abaissement pour prendre le composant (80, 81, 82), à la fois pour le premier composant (81) et pour le deuxième composant (82), dans lequel
une position d'imagerie (PC1) du composant (80, 81, 82) lorsque le composant (80, 81, 82) est imagé, et la position de prélèvement (PP1) du composant (80, 81, 82) lorsque le composant (80, 81, 82) est prélevé coïncident l'une avec l'autre, et
lorsque le temps du début de l'opération auquel l'opération d'abaissement de l'élément de maintien (30) commence après que le composant (80, 81, 82) est positionné à la position de prélèvement (PP1) est défini comme un premier temps (TG1), et le temps du début de l'opération qui est réglé avant au moins le premier temps (TG1) d'une durée requise entre le temps où l'élément de maintien (30) commence l'opération d'abaissement et le temps où l'élément de maintien (30) atteint le composant (80, 81, 82) est défini comme un deuxième temps (TG2),
la deuxième section de détermination (42) est configurée pour déterminer (S13) que la détermination de l'état d'alimentation n'est pas nécessaire pour le deuxième composant (82), lorsqu'il est déterminé que (S12) un état d'alimentation du premier composant (81) est approprié par la première section de détermination (41), et
la section de réglage du temps (43) est configurée pour régler le premier temps (TG1) pour le premier composant (81) et règle (S15) le deuxième temps (TG2) pour le deuxième composant (82).

2. Monteur de composants selon la revendication 1, dans lequel
une position d'imagerie (PC1) du composant (80, 81, 82) lorsque le composant (80, 81, 82) est imagé, et la position de prélèvement (PP1) du composant (80, 81, 82) lorsque le composant (80) est prélevé coïncident l'une avec l'autre, et
lorsque le temps du début de l'opération où l'opération d'abaissement de l'élément de maintien (30) commence après que le composant (80, 81, 82) est placé à la position de prélèvement (PP1) est défini comme un premier temps (TG1),
la deuxième section de détermination (42) est configurée pour déterminer (S14) que la détermination de l'état d'alimentation est nécessaire pour le deuxième composant (82), lorsqu'il est déterminé (S12) qu'un état d'alimentation du premier composant (81) est inapproprié par la première section de détermination (41), et
la section de réglage du temps (43) est configurée pour régler (S16) le premier temps (TG1) à la fois pour le premier composant (81) et le deuxième composant (82).

3. Monteur de composants selon la revendication 1 ou 2, comprenant en outre :
une section d'initialisation (45) configurée pour amener la première section de détermination (41), la deuxième section de détermination (42) et la section de réglage du temps (43) à exécuter un traitement sur le composant fourni par le dispositif d'alimentation en composants (12) échangé lorsque le dispositif d'alimentation en composants (12) fournissant le deuxième composant (82) est échangé ou lorsqu'un échange du dispositif d'alimentation en composants (12) est prévu.

4. Monteur de composants selon l'une quelconque des revendications 1 à 3, comprenant en outre :
une section de contrôle de l'élément de maintien (44) configurée pour contrôler l'élément de maintien (30), dans lequel
le dispositif d'alimentation en composants (12) est configuré pour transmettre une notification d'achèvement indiquant que le composant (80, 81, 82) est positionné à la position de prélèvement (PP1) à la section de contrôle de l'élément de maintien (44) sur la base du temps de début d'opération défini par la section de réglage du temps (43), et
la section de contrôle de l'élément de maintien (44) est configurée pour commencer l'opération d'abaissement de l'élément de maintien (30), lorsque la section de contrôle de l'élément de maintien (44) reçoit la notification d'achèvement de la part du dispositif d'alimentation en composants (12).

5. Monteur de composants selon l'une quelconque des revendications 1 à 4, dans lequel
la première section de détermination (41) est configurée pour déterminer (S12) que l'état d'alimentation du premier composant (81) est inapproprié lorsqu'au moins l'un de la position et de l'angle du premier composant (81) lorsque le premier composant (81) est positionné à la position d'imagerie (PC1) n'est pas compris dans la plage prédéterminée.

6. Monteur de composants selon la revendication 5, comprenant en outre :
une section de contrôle de l'élément de maintien (44) configurée pour contrôler l'élément de maintien (30), dans lequel
la première section de détermination (41) est configurée pour acquérir la position et l'angle du premier composant (81) lorsque le premier composant (81) est positionné à la position d'imagerie (PC1), sur la base d'une forme extérieure et d'une position centrale du premier composant (81) obtenues par traitement d'image d'une image capturée obtenue par imagerie du premier composant (81), et
la section de contrôle de l'élément de maintien (44) est configurée pour corriger une position et un angle de l'élément de maintien (30) et pour monter le premier composant (81) sur la carte (90), sur la base d'une position du premier composant (81) dans l'élément de maintien (30) obtenue par traitement d'image de l'image capturée obtenue par imagerie du premier composant (81) tenu par l'élément de maintien (30).

7. Monteur de composants selon l'une quelconque des revendications 1 à 6, dans lequel
le dispositif d'alimentation en composants (12) est configuré pour fournir le même type de composant (80, 81, 82) fabriqué dans le même lot du même fabricant.

8. Monteur de composants selon l'une quelconque des revendications 1 à 7, dans lequel le premier composant (81) est un premier composant (81) fourni d'abord par le dispositif d'alimentation en composants (12).

9. Procédé de prélèvement de composants appliqué à un monteur de composants (10) comprenant un dispositif d'alimentation en composants (12) configuré pour fournir séquentiellement des composants (80, 81, 82) à monter sur une carte (90), le procédé comprenant :
une première étape de détermination d'exécution de détermination de l'état d'alimentation (S11) par imagerie du composant (80, 81, 82) à l'aide d'un dispositif d'imagerie (14, 15) avant que le composant (80, 81, 82) ne soit prélevé à une position de prélèvement (PP1) ;
**caractérisé par**
déterminer (S12) si un état d'alimentation du composant (80, 81, 82) dans le dispositif d'alimentation en composants (12) est approprié pour les premiers composants (81) qui sont un nombre prédéterminé de composants (80, 81, 82) plus petit que le nombre de composants (80, 81, 82) fournis par le dispositif d'alimentation en composants (12) à la carte (90), dans lequel
il est déterminé (S12) que l'état d'alimentation du premier composant (81) est approprié lorsqu'une position et un angle du premier composant (81), lorsque le premier composant (81) est positionné à une position d'imagerie (PC1), sont compris dans une plage prédéterminée ; et
une deuxième étape de détermination (S13, S14) de la nécessité de la détermination de l'état d'alimentation pour un deuxième composant (82) qui est le composant (80, 81, 82) fourni par le dispositif d'alimentation en composants (12) après que le premier composant (81) a été fourni, sur la base d'un résultat de la détermination par la première étape de détermination (S12) ; et
une étape de réglage du temps (S15, S16) consistant à régler un temps de début d'opération, auquel un élément de maintien (30), saisissant et maintenant le composant (80, 81, 82) pour monter le composant (80, 81, 82) sur la carte (90), commence une opération d'abaissement pour saisir le composant (80, 81, 82), pour le premier composant (81) et le deuxième composant (82), dans lequel
une position d'imagerie (PC1) du composant (80, 81, 82) lorsque le composant (80, 81, 82) est imagé, et la position de prélèvement (PP1) du composant (80, 81, 82) lorsque le composant (80, 81, 82) est prélevé coïncident l'une avec l'autre, et
lorsque le temps du début de l'opération auquel l'opération d'abaissement de l'élément de maintien (30) commence après que le composant (80, 81, 82) est positionné à la position de prélèvement (PP1) est défini comme un premier temps (TG1), et le temps du début de l'opération qui est réglé avant au moins le premier temps (TG1) d'une durée requise entre le temps où l'élément de maintien (30) commence l'opération d'abaissement et le temps où l'élément de maintien (30) atteint le composant (80, 81, 82) est défini comme un deuxième temps (TG2),
il est déterminé (S13) que la détermination de l'état d'alimentation n'est pas nécessaire pour le deuxième composant (82), lorsqu'il est déterminé que (S12) un état d'alimentation du premier composant (81) est approprié, et
le premier temps (TG1) est réglé pour le premier composant (81) et le deuxième temps (TG2) est réglé (S15) pour le deuxième composant (82).
